# DEMANDE DE BREVET EUROPEEN

(11) **EP 1 306 945 A1**
(43) Date de publication de la demande: **02.05.2003**
(21) Numéro de dépôt: 02292289.2
(22) Date de dépôt: 18.09.2002
(51) Int. Cl.: H01S 5/22

(54) **Composant optique semi-conducteur et procédé de fabrication d'un tel composant**

(30) Priorité: 20.09.2001 FR 0112342
(71) Demandeur: Alcatel Optronics France, 75008 Paris (FR)
(72) Inventeur: Garabedian, Patrick, 91650 Breuillet (FR); Brot, Christian, 38420 Revel (FR)
(74) Mandataire: Lenne, Laurence

(57) **Abrégé**

La présente invention concerne un composant optique semi-conducteur (10) comprenant une région d'injection de courant (I) et au moins une région électriquement isolée (P₁, P₂) dite premier plateau, contenant chacune une couche de contact (5_{P}, 5_{I}) en un alliage à base d'arséniure de gallium, GaAs, déposée sur une couche de confinement dite supérieure (23_{P}, 23_{I}) en un matériau semi-conducteur, ledit composant comprenant en outre au niveau dudit premier plateau une couche d'isolation (7) en un matériau diélectrique située au-dessus de ladite couche de contact. Selon l'invention, une couche dite d'accrochage (6_{P}) est interposée entre ladite couche de contact et ladite couche d'isolation de manière à accroître l'adhérence de ladite couche d'isolation sur ladite couche de contact. L'invention concerne également un procédé de fabrication d'un tel composant.

## Description

La présente invention concerne le domaine des composants optiques. Plus précisément, elle concerne un composant optique semi-conducteur ainsi qu'un procédé de fabrication d'un tel composant.

De manière connue, un composant optique semi-conducteur de type laser à base d'arséniure de gallium est souvent utilisé pour le pompage de lasers solides ou d'amplificateurs optiques à fibres dopées terres rares. Le fonctionnement d'un tel composant est basé sur l'utilisation d'une couche dite active qui, une fois alimentée en courant, émet des rayonnements qui peuvent être amplifiés et correspondre à des rayonnements lasers, de longueurs d'onde généralement comprises dans une bande autour de 808 nm, 920 nm, 940 nm, et en particulier 980 nm, cette dernière longueur d'onde étant utilisée pour le pompage des amplificateurs à fibre monomode employés dans les applications de télécommunications optiques. De plus, ce composant optique souvent de type parallélépipédique peut posséder des faces latérales avant et arrière clivées pour former des miroirs facettés afin que s'établissent dans le composant des modes de propagation longitudinaux de type Fabry-Pérot.

Dans tout ce qui suit, le terme couche peut désigner une couche unique ou une superposition de couches remplissant la même fonction.

Au-dessus de la couche active, le composant optique semi-conducteur comprend généralement deux régions électriquement isolées dites plateaux du fait de leur forme, ces plateaux étant situés de part et d'autre d'une région d'injection de courant dans laquelle le courant pénètre au sein du composant.

Les plateaux et la région d'injection de courant contiennent chacun une couche dite de contact servant dans la région d'injection de courant à la prise de contact ohmique c'est-à-dire à la bonne circulation du courant vers la couche active. La couche de contact, généralement en un alliage à base d'arséniure de gallium (GaAs), est déposée sur une couche de confinement dite supérieure, en un matériau semi-conducteur, qui contribue au guidage des rayonnements émis par la couche active.

Les couches active, de confinement supérieure et de contact en matériaux semi-conducteurs monocristallins sont généralement déposées par épitaxie de type MOVPE (Metal Organic Vapor Phase Epitaxy en anglais) ou MBE (Molecular Beam Epitaxy en anglais).

Les plateaux comprennent une couche d'isolation en un matériau diélectrique tel qu'un oxyde de métal (alumine, oxyde de titane...), un polyimide et le plus souvent un nitrure de silicium, choisi pour ses excellentes propriétés diélectriques.

Du fait de la présence de la couche d'isolation, la hauteur des plateaux est sensiblement supérieure à la hauteur de la région d'injection de courant. Dans cette configuration, ces plateaux protègent donc la région d'injection de courant des dommages mécaniques (coups, rayures...) survenant pendant la fabrication du composant et/ou pendant son utilisation. Ce type de configuration est privilégié par rapport aux configurations dites saillantes c'est-à-dire sans région électriquement isolée de type plateau.

Par ailleurs, il existe également des composants avec une région d'injection de courant disposée entre deux régions électriquement isolées en forme de canal, situées de part et d'autre de la région d'injection de courant. Ces canaux sont eux mêmes disposés entre deux plateaux protégeant la région d'injection de courant. On parle alors de composant à double canal.

L'adhérence sur le GaAs des matériaux diélectriques précités constituant la couche d'isolation est critique. Les problèmes d'adhérence surviennent pendant l'étape de dépôt même de la couche et/ou postérieurement au dépôt lors d'étapes suivantes de fabrication du composant. Ce manque d'adhérence conduit fréquemment au décollement de la couche d'isolation sur les plateaux. Ce décollement peut notamment se produire lors de traitements thermiques à haute température et/ou lors du clivage du composant. Par exemple, dans ce dernier cas, l'énergie mécanique pour rompre le cristal et délivrée lors du clivage devient supérieure à la force de cohésion de la couche d'isolation avec la couche de contact au voisinage des miroirs facettés. Un espace plus ou moins important se forme alors entre la couche d'isolation et la couche de contact.

Les défauts d'adhérence et le décollement sont susceptibles de se propager jusqu'aux bords de la région d'injection de courant. Ceci introduit un étalement des lignes de courant, les fuites de courant en surface conduisant à un élargissement de la région d'injection de courant au niveau de la couche active, ce qui modifie défavorablement les propriétés électro-optiques du composant. De plus, l'éventualité d'un tel décollement réduit la fiabilité du composant et sa longévité.

La présente invention a pour premier but de mettre au point un composant optique semi-conducteur fiable et performant en s'affranchissant des problèmes d'adhérence et de décollement de la couche d'isolation sur la couche de contact.

L'invention propose à cet effet un composant optique semi-conducteur comprenant une région d'injection de courant et au moins une région électriquement isolée dite premier plateau, contenant chacune une couche de contact en un alliage à base d'arséniure de gallium, GaAs, déposée sur une couche de confinement dite supérieure en un matériau semi-conducteur, ledit composant comprenant en outre au niveau dudit premier plateau une couche d'isolation en un matériau diélectrique située au-dessus de ladite couche de contact,
**caractérisé en ce qu**'une couche dite d'accrochage est interposée entre ladite couche de contact et ladite couche d'isolation de manière à accroître l'adhérence de ladite couche d'isolation sur ladite couche de contact.

On choisit pour la couche d'accrochage le matériau adéquat afin de favoriser l'adhérence de la couche d'isolation non seulement lors du dépôt mais aussi lors des étapes ultérieures de fabrication du composant (traitements thermiques, clivage...).

Avant le dépôt, on peut en outre envisager un préparation de surface de la couche d'accrochage, par exemple par voie humide en utilisant un désoxydant et/ou par voie sèche en effectuant un bref décapage. De même, on peut choisir d'optimiser les conditions de dépôt par exemple en réalisant un dépôt de type PECVD (Plasma Enhanced Chemical Vapor Deposition en anglais) avec un plasma contenant des ions de forte énergie. Dans un composant de l'art antérieur, un tel décapage et un dépôt à forte énergie de la couche d'isolation ne sont pas envisageables. En effet, les ions énergétiques en bombardant la couche de contact endommagent sa surface.

Avantageusement, la couche d'accrochage selon l'invention peut être en un alliage à base de phosphore, et de préférence en un alliage à base de phosphore, de gallium et d'indium, tel que l'InGaP₂.

De cette façon, la couche d'accrochage peut être épitaxiée à haute température immédiatement après la couche de contact dans une même séquence d'épitaxie sans remise à l'air du composant. Ceci ne nécessite pas de préparation de surface particulière de la couche de contact car ces couches sont en adaptation de paramètre de maille. De plus, un dépôt par épitaxie est réalisé dans des conditions telles que la surface de la couche de contact n'est pas endommagée pendant la phase de nucléation de la couche d'accrochage.

En outre, contrairement à l'art antérieur, on peut employer un désoxydant tel qu'un acide sulfurique pour préparer le dépôt de la couche d'isolation sans altérer la couche de contact sous-jacente.

Avantageusement, la couche d'accrochage selon l'invention peut avoir une épaisseur comprise entre 20 nm et 5000 nm et de préférence de l'ordre de 1000 nm.

Pour résoudre les problème d'adhérence, une épaisseur de l'ordre de 20 à 30 nm suffit. Toutefois, le dépôt d'une couche plus épaisse présente un autre avantage. En effet, la région d'injection de courant ne comprenant pas de couche d'accrochage, plus l'épaisseur de cette couche est importante, plus la différence de hauteurs entre le ou les plateaux et la région d'injection de courant est augmentée. Ainsi, avec un dépôt de l'ordre de 1000 nm, la région d'injection de courant est mieux protégée des dommages mécaniques.

Selon l'invention, la couche d'isolation peut être en un matériau diélectrique choisi parmi les polyimides, les oxydes de métaux, la silice, les nitrures, et de préférence parmi les nitrures de silicium.

On peut employer des oxydes de métaux tels que l'alumine. Les nitrures de silicium sont des matériaux à base d'azote et de silicium pouvant également contenir en quantité moindre de l'oxygène et/ou de l'hydrogène. Ces nitrures sont particulièrement préconisés du fait de leurs excellentes propriétés isolantes et de leur tenue aux traitements thermiques ou aux gravures intervenant lors de la fabrication du composant.

Dans un mode de réalisation de l'invention, le composant optique comprend en outre une région électriquement isolée dite premier canal entre le premier plateau et la région d'injection de courant.

Dans ce mode de réalisation, le composant optique peut comprendre en outre un deuxième plateau identique au premier plateau et un deuxième canal identique au premier canal disposé entre le deuxième plateau et la région d'injection de courant de sorte que les premier et deuxième canaux sont situés de part et d'autre de la région d'injection de courant.

Ainsi un composant selon l'invention peut être à double canal.

Selon l'invention, la région d'injection de courant, ainsi que le ou les plateaux peuvent être de forme sensiblement parallélépipédique. En outre, la hauteur de la région d'injection de courant peut être sensiblement inférieure à la hauteur du ou des plateaux.

Une forme parallélépipédique est facilement réalisable par gravure et simplifie donc certaines étapes de fabrication d'un composant selon l'invention.

Le composant optique selon l'invention peut comprendre en outre un substrat de type GaAs sur lequel sont déposées successivement sur une même face :
- une couche de confinement dite inférieure en un matériau semi-conducteur de préférence semblable au matériau de la couche de confinement supérieure,
- une couche active destinée à produire des rayonnements de type laser,
- une couche de confinement dite intermédiaire en un matériau semi-conducteur de préférence semblable au matériau de la couche de confinement inférieure,
- une couche dite de couverture intermédiaire en un alliage à base de phosphore, la couche de confinement supérieure étant déposée sur la couche de couverture intermédiaire,
- une couche électrode en un matériau métallique couvrant la ou les régions électriquement isolées et la région d'injection de courant.

Dans un composant de l'art antérieur comme dans le composant selon l'invention, la couche électrode du ou des plateaux est déposée sur la couche d'isolation. Dans un composant de l'art antérieur, le dépôt de cette couche induit des contraintes biaxiales dans la couche d'isolation ce qui a pour effet d'accroître les problèmes d'adhérence sur la couche de contact. Dans le composant selon l'invention, la couche d'accrochage interposée entre ces dernières couches minimise les conséquences de l'apparition de ces contraintes. Elle remplit donc une nouvelle fois son rôle de promoteur d'adhérence.

De plus, la couche électrode nécessite un traitement thermique à des température élevées entre 400°C et 500°C pour former le contact ohmique. Dans l'art antérieur, ce traitement thermique dégrade encore l'adhérence de la couche d'isolation sur la couche de contact. Dans le composant selon l'invention, la couche d'accrochage interposée entre ces dernières couches augmente de façon surprenante l'adhérence de la couche d'isolation au lieu de la dégrader.

Un test d'adhérence par éraflure (scratching test en anglais) a été effectué. Ce test a ainsi mesuré la force de décohésion nécessaire pour désolidariser une couche d'isolation en nitrure de silicium sur une couche en GaAs telle que la couche de contact et sur une couche en InGaP₂ telle que la couche d'accrochage selon l'invention après un tel traitement thermique à haute température. Quels que soient le désoxydant utilisé avant le dépôt et les conditions de dépôt choisies, la force de décohésion nécessaire avec un substrat InGaP₂ est toujours supérieure de plusieurs millinewtons à celle avec un susbstrat en GaAs.

Par ailleurs, la couche de couverture intermédiaire peut être utilisée comme dans l'art antérieur pour ajuster la hauteur des éventuels canaux. Ces derniers comprennent en outre la couche d'isolation déposée sur cette couche intermédiaire.

Ainsi, de préférence, l'alliage de la couche d'accrochage peut être identique à l'alliage de la couche de couverture intermédiaire.

De cette façon, la couche d'isolation est déposée au sommet des plateaux et dans les éventuels canaux sur des couches d'un même alliage.

La présente invention concerne également un procédé de fabrication d'un composant optique semi-conducteur comprenant une région d'injection de courant et plusieurs régions électriquement isolées, éventuellement de hauteurs supérieures à celle de la région d'injection de courant afin de la protéger des dommages mécaniques. Ces régions électriquement isolées peuvent comprendre des plateaux principalement en matériau diélectrique ou également avec des couches semi-conductrices. Dans ce dernier cas, les plateaux sont de préférence associés à des canaux pour former une structure double canal. Dans une autre configuration, ces régions électriquement isolées peuvent être en creux de part et d'autre de la région d'injection de courant restant saillante.

Pour toutes ces configurations, de manière connue, un procédé de fabrication d'un tel composant optique semi-conducteur souvent de type parallélépipédique comprend d'abord une série de dépôts successifs par épitaxie de type MOVPE ou MBE sur une même face d'un substrat en GaAs:
- dépôt d'une couche de confinement dite inférieure en AlₓGa₁₋ₓAs,
- dépôt d'une couche active destinée à produire des rayonnements de type laser, contenant au moins un puits quantique entre deux couches en GaAs,
- dépôt d'une couche de confinement dite intermédiaire en Al_{y}Ga_{1-y}As,
- dépôt d'une couche de confinement dite supérieure en Al_{z}Ga_{1-z}As,
- dépôt d'une couche de contact en GaAs.

Le procédé peut également comprendre une étape de dépôt d'une couche dite de couverture intermédiaire en InGaP₂ située entre la couche de confinement supérieure et la couche de confinement intermédiaire. Cette couche est principalement utilisée pour la fabrication de composants à double canal.

La majorité des couches semi-conductrices situées au-dessus de la couche active possèdent un dopage de type p et par symétrie celles en dessous de la couche active un dopage de type n de même que le substrat.

Le dopage correspond à l'addition délibérée d'impuretés qui sont des donneurs d'électrons pour un dopage de type n (conduction par les électrons) ou des accepteurs d'électrons pour un dopage de type p (conduction par les trous ou charges positives).

A la suite de ces dépôts, est déposée généralement par PECVD une couche dite de masquage en un matériau diélectrique sur la couche de contact en GaAs. Cette couche sert de support pour une photolithographie. Le choix d'un matériau diélectrique du type nitrure de silicium Si₃N₄ au lieu d'une résine photosensible pour le masquage est souvent justifié par le fait que ce dernier est moins sensible aux plasmas utilisés par la suite pour les gravures. De cette façon, les couches situées en dessous de la couche de masquage sont mieux protégées.

Après masquage, intervient ainsi une étape de gravure par voie sèche de type RIE (Reactive Ion Etching en anglais) ou par voie humide à l'aide d'un bain chimique. Cette étape élimine partiellement la couche de masquage, par exemple dans les régions destinées à former les canaux ou les régions en creux. Elle est suivie d'une autre étape de gravure supprimant dans ces régions la couche de contact et la couche de confinement supérieure sous-jacentes soit par voie humide par une attaque sélective du GaAs à l'aide d'acide sulfurique et d'eau oxygénée, soit par voie sèche à l'aide de plasmas chlorés.

Une autre étape de gravure dite de démasquage vient supprimer entièrement la couche de masquage, généralement par voie humide avec de l'acide fluorhydrique dilué ou par procédé plasma peu énergétique en chimie fluorée.

Ensuite, une couche dite d'isolation en matériau diélectrique de type polyimide ou de préférence en Si₃N₄ est déposée par PECVD de manière à couvrir toutes les régions. Ce dépôt est plus ou moins épais suivant la configuration souhaitée pour le composant, l'épaisseur pouvant être inférieure ou supérieure à la hauteur avant dépôt de la partie destinée à former la région d'injection de courant.

Une étape ultérieure dite d'ouverture supprime la couche d'isolation au moins dans la partie destinée à former la région d'injection de courant, et éventuellement dans certaines régions électriquement isolées de façon à aplanir la surface du composant et/ou simplement à réduire l'épaisseur de la couche d'isolation de façon à réduire la hauteur de ces régions. Cette étape d'ouverture est réalisée de préférence par voie sèche.

Une étape ultérieure dite de métallisation consiste en un dépôt d'une couche électrode comprenant généralement une multicouche métallique de type Ti/Pt/Au. Cette couche électrode recouvre toutes les régions et permet de reprendre un contact ohmique avec des fils d'or d'amenée de courant soudés par thermo-compression. Cette étape de métallisation comprend un traitement thermique post dépôt à haute température.

De plus, le procédé comprend ensuite une étape de clivage des faces latérales avant et arrière du composant.

Le premier problème rencontré dans le procédé de fabrication de l'art antérieur présenté ci-dessus concerne l'adhérence sur le GaAs de matériaux diélectriques tels que le Si₃N₄. Ce manque d'adhérence conduit fréquemment au décollement de la couche de masquage et/ou de la couche d'isolation.

Le deuxième problème rencontré dans un tel procédé concerne une augmentation anormale des résistances électriques en série de chaque couche semi-conductrice et des interfaces de la région d'injection de courant et principalement de la couche de contact en GaAs dopée p.

Cette augmentation peut résulter de la dégradation de la qualité de la surface de la couche de contact, dégradation causée par les différentes étapes de gravure par voie sèche ainsi que par les dépôts par PECVD des couches diélectriques sur cette couche de contact. En effet, ces dépôts et ces gravures sont effectués avec des plasmas contenant des ions très énergétiques qui par bombardement endommagent la couche de contact en GaAs en induisant des défauts cristallins (distorsion du réseau, lacunes, interstices...). Ces défauts sont associés à des niveaux électriques de type n, défauts non favorables à l'obtention du contact ohmique de type p. Cette compétition entre une forme de dopage de type n et le dopage initial de type p a pour effet d'accroître la résistance électrique de l'interface couche de contact/couche électrode. De plus, lors de ces dépôts, de l'hydrogène atomique accéléré par le plasma sur la surface de la couche de contact est suffisamment énergétique pour diffuser dans la masse de la couche de contact semi-conductrice et pour former des complexes H-dopants de type n passivant la contribution électrique des porteurs de charge de type p de la couche.

Une autre cause d'augmentation de la résistance est attribuée à la réactivité de surface de la couche de contact vis-à-vis des solutions de nettoyage de type basique utilisées pour retirer les masques de photolithographie ou bien certaines solutions utilisées pour désoxyder les surfaces telle que l'acide sulfurique qui permet de favoriser l'adhérence sur la couche de couverture intermédiaire en alliage à base de phosphore avant le dépôt de la couche d'isolation. Ces solutions attaquent d'abord la surface de la couche de contact et, lors du rinçage à l'eau, cette attaque se propage dans la masse.

La présente invention a donc pour second but la mise en point d'un procédé de fabrication d'un composant optique semi-conducteur comprenant une région d'injection de courant et une ou plusieurs régions électriquement isolées, procédé facile à mettre en oeuvre et garantissant les performances du composant obtenu ceci en éliminant les problèmes d'adhérence et les problèmes d'augmentation de résistance.

A cet effet, l'invention propose un procédé de fabrication d'un composant optique semi-conducteur comprenant une région d'injection de courant et au moins une région électriquement isolée et comportant les étapes suivantes :
- une étape de dépôt d'une couche de contact en un alliage à base de GaAs sur une couche de confinement dite supérieure en un matériau semi-conducteur,
- une étape ultérieure de dépôt d'une couche dite de masquage en un matériau diélectrique de type nitrure de silicium sur ladite couche de contact,
**caractérisé en ce qu'**il comporte en outre une étape intermédiaire de dépôt d'une couche dite d'accrochage entre ladite couche de contact et ladite couche de masquage de manière à accroître l'adhérence de ladite couche de masquage sur ladite couche de contact.

On choisit pour la couche d'accrochage le matériau adéquat afin de favoriser l'adhérence de la couche de masquage non seulement lors du dépôt mais aussi lors des étapes ultérieures de fabrication du composant.

Avant le dépôt de la couche de masquage, on peut en outre envisager un préparation de surface de la couche d'accrochage, par exemple par voie humide en utilisant un désoxydant et/ou par voie sèche en effectuant un bref décapage. De même, on peut choisir d'optimiser les conditions de dépôt par exemple en réalisant un dépôt à forte énergie.

Comme indiqué précédemment, dans un procédé de l'art antérieur le dépôt par PECVD à forte énergie de la couche de masquage endommage la couche de contact. Ce problème est résolu selon l'invention en interposant la couche d'accrochage.

Avantageusement, la couche d'accrochage peut être en un alliage à base de phosphore, et de préférence en un alliage à base de phosphore, de gallium et d'indium, tel que l'InGaP₂.

De cette façon, le dépôt de la couche d'accrochage peut être réalisé également par épitaxie immédiatement à la suite du dépôt de la couche de contact sans ressortir le composant du réacteur d'épitaxie. Ceci ne nécessite pas de préparation de surface particulière de la couche de contact car ces couches sont en adaptation de paramètre de maille. De plus, un dépôt par épitaxie est réalisé dans des conditions telles que la surface de la couche de contact n'est pas endommagée pendant la phase de nucléation. De la même manière, il n'y pas d'hydrogénation de la couche de contact pendant ce dépôt car un dépôt par épitaxie est réalisé à haute température ce qui favorise une exodiffusion de l'hydrogène qui de plus n'est pas accéléré par la présence d'un champ électromagnétique comme lors d'un dépôt de type PECVD.

En outre, on peut employer un désoxydant tel qu'un acide sulfurique pour préparer le dépôt de la couche d'isolation sans altérer la couche de contact.

Le procédé de fabrication selon l'invention peut comporter en outre préalablement au dépôt de la couche de confinement supérieure les étapes successives de dépôt suivantes sur une même face d'un substrat de type GaAs :
- dépôt d'une couche de confinement dite inférieure en un matériau semi-conducteur de préférence semblable au matériau de la couche de confinement supérieure,
- dépôt d'une couche active destinée à produire des rayonnements de type laser,
- dépôt d'une couche de confinement dite intermédiaire, en un matériau semi-conducteur de préférence semblable au matériau de la couche de confinement inférieure.

Le procédé selon l'invention peut comporter en outre après le dépôt de la couche de confinement intermédiaire une étape de dépôt d'une couche dite de couverture intermédiaire en un alliage à base de phosphore, la couche de confinement supérieure étant déposée sur la couche de couverture intermédiaire.

Cette couche de couverture intermédiaire va permettre, pour les composants à région d'injection de courant saillante, de définir l'arrêt de la gravure des régions électriquement isolées en creux situées de part et d'autre et, pour les composants à double canal, de régler la hauteur des canaux. On ajuste ainsi l'épaisseur de la couche de confinement supérieure de part et d'autre de la région d'injection de courant. Le choix de cette épaisseur participe avec la largeur de la région d'injection de courant et les compositions des couches de confinements et de la couche active à définir les propriétés de guidage du composant.

Le procédé selon l'invention peut comporter en outre après le dépôt de la couche de masquage les étapes suivantes :
- une étape d'élimination partielle de la couche de masquage de manière à laisser partiellement apparente ladite couche d'accrochage,
- une étape ultérieure de gravure pour supprimer, au niveau de la ou des parties laissées apparentes par l'étape d'élimination, la couche d'accrochage, la couche de contact sous-jacente ainsi que la couche de confinement supérieure sous-jacente,
- une étape ultérieure de dépôt d'une couche dite d'isolation en un matériau diélectrique de type nitrure de silicium,
- une étape ultérieure dite d'ouverture pour supprimer la couche d'isolation au moins au niveau d'une partie où la couche d'accrochage est encore présente destinée à former la région d'injection de courant.

L'étape d'élimination partielle de la couche de masquage impliquant une photolithographie laisse apparente une ou plusieurs parties de la couche d'accrochage et non comme dans l'art antérieur, la couche de contact. Après cette étape, sont utilisées des solutions de nettoyage déjà citées nuisibles dans l'art antérieur. Dans le procédé selon l'invention, la couche d'accrochage moins sensible à ces solutions préserve la couche de contact.

Lors de l'étape ultérieure de gravure, il est possible de commencer la gravure sous plasma chloré à forte énergie afin de retirer la couche d'accrochage puis de continuer à basse énergie ce qui est suffisant pour retirer les couches de contact à base de GaAs et de confinement supérieure souvent à base de AlₓGa₁₋ₓAs. De cette façon, la couche de couverture intermédiaire à base de phosphore peut ainsi définir l'arrêt de la gravure.

De plus, dans la partie destinée à former la région d'injection de courant, le dépôt de la couche d'isolation est réalisé sur la couche d'accrochage de sorte que la surface de la couche de contact est également préservée du bombardement possible des ions pendant le dépôt de la couche d'isolation, et de la même façon il n'y pas d'hydrogénation dans la couche de contact, en particulier pendant le dépôt par épitaxie de la couche d'accrochage à base de phosphore, de gallium et d'indium. Ainsi, l'adhérence de la couche d'isolation peut être optimisée de la même façon que celle de la couche de masquage.

En outre, dans les composants à double canal ou dans les composants à région d'injection de courant saillante, les parties destinées à former les canaux ou les régions électriquement isolées en creux comportent la couche d'isolation qui peut être déposée sur une couche intermédiaire à base de phosphore. Ainsi, dans ces régions, l'adhérence de la couche d'isolation est également maîtrisée.

Le procédé selon l'invention peut comporter en outre une autre étape de gravure dite de démasquage entre l'étape de gravure et l'étape de dépôt d'une couche d'isolation pour supprimer entièrement la couche de masquage.

Ceci permet notamment d'éviter une surépaisseur inutile des couches en matériau(x) diélectrique(s).

Le procédé selon l'invention peut comporter en outre après l'étape d'ouverture une étape de décapage pour supprimer la couche d'accrochage au niveau de la partie destinée à former la région d'injection de courant.

La couche d'accrochage selon l'invention peut être en un alliage à base de phosphore qui est à large bande interdite. La bande interdite correspond à la différence d'énergie entre le point le plus bas de la bande de conduction et le point le plus haut de la bande de valence. Il est important dans un tel cas de supprimer cette couche au niveau de la partie destinée à former la région d'injection de courant. En effet, le contact ohmique avec la couche active et les couches de confinement sous-jacentes est rompu du fait de cette large bande interdite car cet alliage semi-conducteur à grande largeur de bande interdite n'est pas favorable à l'obtention d'un interface métal/semi-conducteur de type ohmique à faible résistivité électrique de contact.

Cette étape de décapage peut être réalisée par voie humide par exemple avec un bain d'acide chlorhydrique dilué. Il n'est pas nécessaire de réaliser une photolithographie car la couche d'isolation protège toutes les autres régions et joue donc le rôle de masque de gravure. De plus, un tel acide ne contamine pas la couche de contact en GaAs dans la région d'injection de courant.

Le procédé selon l'invention peut comporter en outre après l'étape de décapage une étape dite de métallisation comprenant le dépôt d'une couche électrode en un matériau métallique pour recouvrir la ou les régions électriquement isolées ainsi que la région d'injection de courant.

Dans l'art antérieur, le dépôt de cette couche induit des contraintes biaxiales dans la couche d'isolation ce qui a pour effet d'augmenter les problèmes d'adhérence sur la couche de contact. Dans le procédé selon l'invention, la couche d'accrochage interposée entre ces dernières couches minimise les conséquences de l'apparition de ces contraintes sur l'adhérence. Elle remplit donc une nouvelle fois son rôle de promoteur d'adhérence.

Un composant optique semi-conducteur obtenu par un procédé de fabrication selon l'invention peut posséder deux régions électriquement isolées disposées de part et d'autre de la région d'injection de courant telles que les régions en creux prédéfinies.

Les caractéristiques et objets de la présente invention ressortiront de la description détaillée donnée ci-après en regard des figures annexées, présentées à titre illustratif et nullement limitatif.

Dans ces figures :
- la figure 1 représente une vue schématique en coupe d'un composant optique semi-conducteur selon l'invention,
- les figures 2 à 9 représentent les étapes d'un procédé de fabrication selon l'invention d'un composant optique semi-conducteur,
- la figure 10 représente une vue schématique en coupe d'un composant optique semi-conducteur selon l'invention obtenu par un procédé de fabrication selon l'invention.
- la figure 11 représente une vue schématique en coupe d'une variante d'un composant optique semi-conducteur selon l'invention obtenu par un procédé de fabrication selon l'invention.

Dans toutes ces figures les éléments communs, c'est-à-dire remplissant la même fonction, sont désignés par les mêmes numéros de référence.

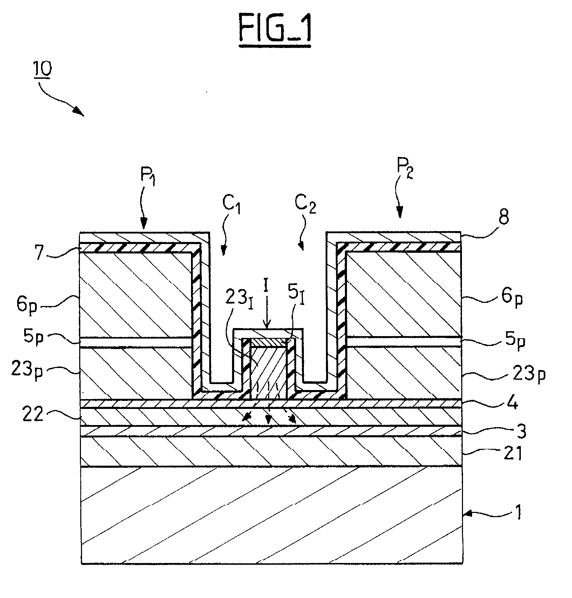

On a représenté en figure 1 une vue schématique en coupe d'un composant optique semi-conducteur 10 selon l'invention utilisé comme source de pompage dans des fibres optiques.

Le composant 10 comprend un substrat 1 en GaAs dopé n sur lequel est déposé par épitaxie de type MOVPE ou MBE:
- une couche de confinement dite inférieure 21 dopée n, formée d'une multicouche de composition variable en AlₓGa₁₋ₓAs (x variant de 0,45 à 0,18) d'épaisseur totale de l'ordre de 2 µm,
- une couche active 3 destinée à produire des rayonnements de type laser, contenant au moins un puits quantique en InₓGaAs (x étant de l'ordre de 0,15) entre deux couches en GaAs,
- une couche de confinement dite intermédiaire 22 dopée p, formée d'une multicouche de composition variable en AlₓGa₁₋ₓAs (x variant de 0,18 à 0,45) d'épaisseur totale de l'ordre de 0,6 µm,
- une couche dite de couverture intermédiaire 4 en InGaP₂ dopée p d'épaisseur de l'ordre de 0,02 µm et de largeur de bande interdite identique à l'Al_{0,45}Ga_{0,55}As afin de ne pas introduire de saut d'indice dans la structure et donc de ne pas modifier les propriétés de guidage du composant 10.

Le substrat 1 peut comprendre en outre une couche dite tampon en GaAs épitaxiée (non représentée) par exemple de quelques dixièmes de micron afin de favoriser la croissances des couches suivantes.

Le composant 10 parallélépipédique fonctionne avec une région d'injection de courant I de 2 µm environ de largeur disposée entre deux canaux dits premier et deuxième canaux C₁ et C₂, eux-mêmes disposés entre deux régions plateaux dites premier et deuxième plateaux P₁ et P₂. Ces régions I, P₁, P₂, C₁ et C₂ sont situées au-dessus de la couche 4 qui fixe l'arrêt de l'étape de gravure destinée à former les premier et deuxième canaux C₁ et C₂. Les premier et deuxième canaux C₁, C₂ de quelques dizaines de microns de largeur délimitent la localisation du courant destiné à alimenter la couche active 3 comme le montrent les flèches F en trait pointillé. Les premier et deuxième plateaux P₁, P₂ d'environ 100 µm de largeur protègent la région d'injection de courant I des dommages mécaniques.

Les premier et deuxième plateaux P₁, P₂ et la région d'injection de courant I comprennent chacun une couche de confinement dite supérieure dopée p, formée d'une multicouche de composition continûment variable en AlₓGa₁₋ₓAs (x variant de 0,45 à 0,18), d'épaisseur totale de l'ordre de 1,5 µm, déposée sur la couche 4, et référencée respectivement 23_{P} et 23_{I}. Sur cette couche est déposée une couche de contact en GaAs dopée p d'épaisseur de l'ordre de 0,05 µm, référencée respectivement 5_{P} et 5_{I}.

La couche 5_{P} des premier et deuxième plateaux P₁, P₂ est recouverte selon l'invention d'une couche dite d'accrochage 6_{P} en InGaP₂, d'épaisseur de l'ordre de 1 µm. Cette couche d'accrochage 6_{P} permet d'accroître l'adhérence sur la couche de contact 5_{P} d'une couche dite d'isolation 7 en nitrure de silicium d'épaisseur de l'ordre de 0,2 µm et déposée par PECVD.

Dans les premier et deuxième canaux C₁, C₂ la couche d'isolation 7 est déposée sur la couche de couverture intermédiaire 4 en InGaP₂. Ainsi, l'accrochage de cette couche 7 peut être à la fois optimisé au sommet des régions de type plateau P₁, P₂ et dans les régions de type canal C₁, C₂.

Enfin, tout le composant est recouvert d'une couche électrode 8 en métal formée typiquement d'une multicouche de type Ti, Pt ou TiN et Au d'épaisseur de l'ordre de 0,5 µm. Cette couche électrode 8 permet de reprendre un contact ohmique avec des fils (non représentés) d'or d'amenée de courant soudés par thermo-compression.

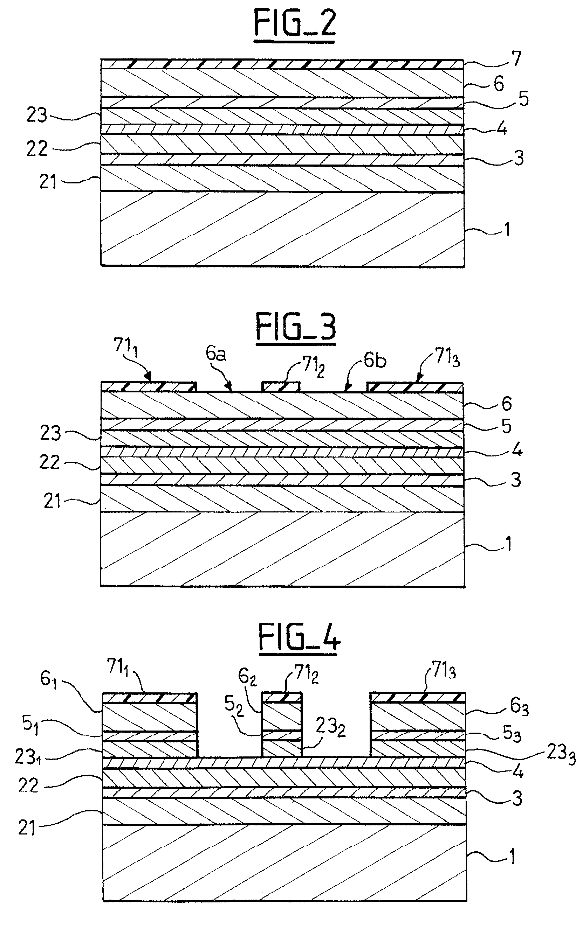

Les figures 2 à 9 représentent les étapes d'un procédé de fabrication selon l'invention d'un composant optique semi-conducteur par exemple parallélépipédique fonctionnant avec une région d'injection de courant disposée entre deux canaux, eux-mêmes disposés entre deux plateaux.

La figure 2 présente le composant obtenu après une série de dépôts successifs par épitaxie de type MOVPE ou MBE sur une même face d'un substrat 1 de type GaAs dopé n:
- dépôt d'une couche de confinement dite inférieure 21 dopée n en AlₓGa₁₋ₓAs,
- dépôt d'une couche active 3 destinée à produire des rayonnements de type laser, contenant un puits quantique entre deux couches en GaAs,
- dépôt d'une couche de confinement 22 dopée p dite intermédiaire en Al_{y}Ga_{1-y}As,
- dépôt d'une couche 4 dite de couverture intermédiaire en InGaP₂ dopée p,
- dépôt d'une couche de confinement 23 dopée p dite supérieure en Al_{z}Ga_{1-z}As,
- dépôt d'une couche de contact 5 en GaAs dopée p.
- dépôt d'une couche dite d'accrochage 6 en InGaP₂.

Cette couche d'accrochage 6 permet d'accroître l'adhérence sur la couche de contact 5 d'une couche dite de masquage 71 en nitrure de silicium d'épaisseur de l'ordre de 0,2 µm et déposée par PECVD. La couche 71 sert de support pour une photolithographie.

La figure 3 présente le résultat de l'étape d'élimination partielle de la couche de masquage 71 de manière à laisser apparentes deux parties de la couche d'accrochage 6a et 6b. Pour le composant à double canal que l'on souhaite obtenir, la couche 71 est alors divisée en trois parties 71₁, 71₂ et 71₃.

La figure 4 présente le résultat d'une étape ultérieure de gravure pour supprimer au niveau des deux parties laissées apparentes 6a et 6b, la couche d'accrochage 6, la couche de contact 5 ainsi que la couche de confinement supérieure 23 sous-jacentes. Ces couches 23, 5 et 6 sont alors respectivement divisées en trois couches 23₁, 23₂ et 23₃, 5₁, 5₂ et 5₃ et 6₁, 6₂ et 6₃. La partie contenant les couches 23₂ à 71₂ est destinée à former la région d'injection de courant. Les couches 23₁ à 71₁ et 23₃ à 71₃ sont contenues dans deux parties destinées à former deux plateaux séparés par deux canaux de la région d'injection de courant.

La figure 5 présente le résultat d'une étape ultérieure de gravure dite de démasquage pour supprimer entièrement la couche de masquage 71.

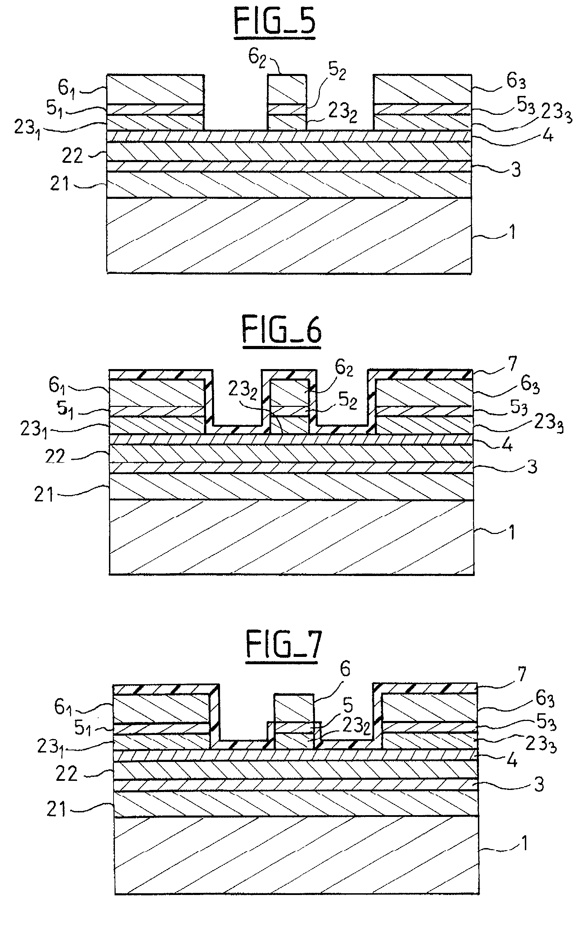

La figure 6 présente le résultat d'une étape ultérieure de dépôt d'une couche dite d'isolation 7 en un matériau diélectrique de type nitrure de silicium.

La figure 7 présente le résultat d'une étape ultérieure dite d'ouverture pour supprimer la couche d'isolation 7 au niveau de la partie destinée à former la région d'injection de courant.

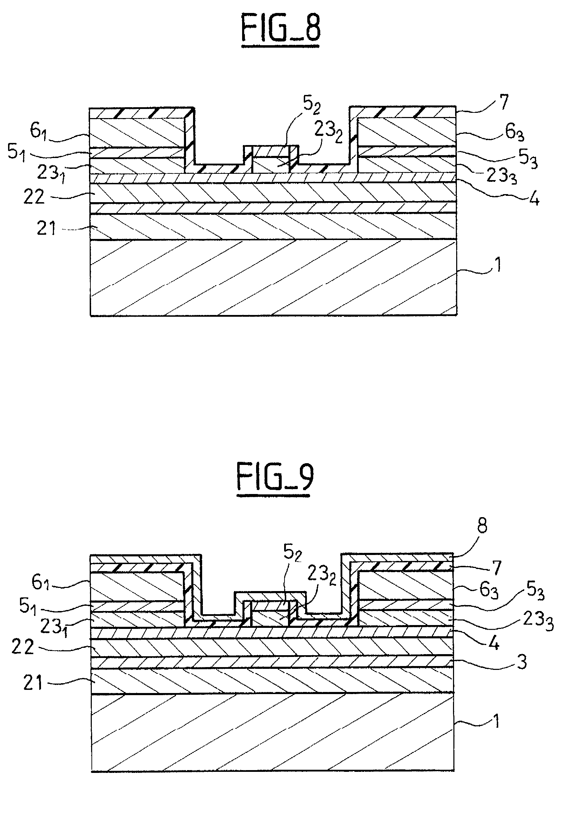

La figure 8 présente le résultat d'une étape ultérieure de décapage souvent par voie chimique pour supprimer la couche d'accrochage 6₂ située sur la couche de contact 5₂ au niveau de la partie destinée à former la région d'injection de courant.

La figure 9 présente le résultat d'une étape ultérieure dite de métallisation comprenant le dépôt d'une couche électrode 8 en un matériau métallique recouvrant toutes les régions.

On obtient ainsi un composant du type de celui de la figure 1.

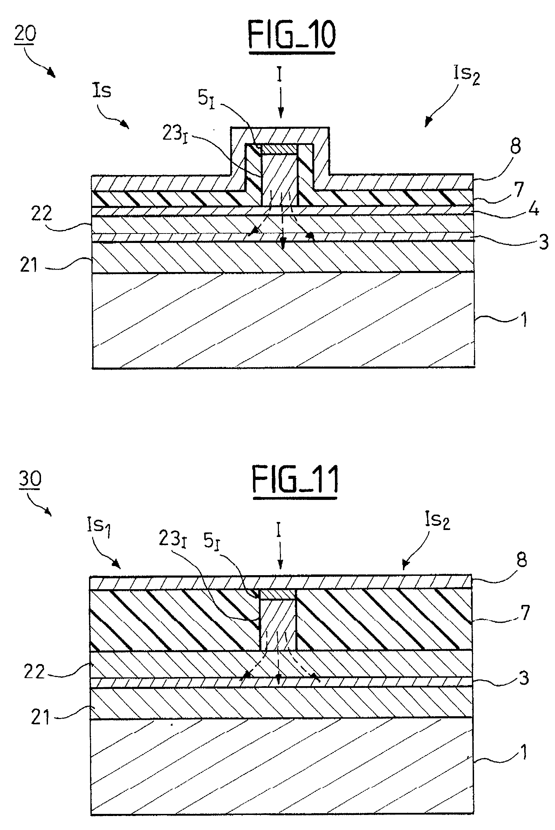

La figure 10 représente une vue schématique en coupe d'un composant optique semi-conducteur selon l'invention 20 également obtenu par un procédé de fabrication selon l'invention tel que décrit en relation avec les figures 2 à 9. Le composant 20 comprend une région d'injection de courant I et de part et d'autre deux régions électriquement isolées Is₁, Is₂ laissant saillante la région I.

L'étape d'élimination partielle décrite en figure 3 laisse dans le composant 20 une seule couche de masquage 71₂.

La figure 11 représente une vue schématique en coupe d'un autre composant optique semi-conducteur selon l'invention 30 obtenu par un procédé de fabrication selon l'invention tel que décrit en relation avec les figures 2 à 9. Le composant 30 comprend une région d'injection de courant I et de part et d'autre deux régions électriquement isolées Is₁, Is₂ de même hauteur que la région I.

Pour le composant 30, la série de dépôts décrite en figure 2 ne comprend pas le dépôt d'une couche de couverture intermédiaire.

L'étape d'élimination partielle décrite en figure 3 laisse dans le composant 30 une seule couche de masquage 71₂.

En outre, le dépôt d'une couche dite d'isolation 7 décrit en figure 6 est plus épais de sorte que la hauteur des parties destinées à former les régions électriquement isolées Is₁, Is₂ est identique après ce dépôt à la hauteur de la partie destinée à former la région d'injection de courant I.

Les modes de réalisation présentés sont des lasers monomode transverse. L'invention s'applique également à des lasers dont la propagation de la lumière est de type multimode transverse et dans lesquels la couche de confinement supérieure et la couche de contact ne sont pas gravées, tels que les lasers dits à contact large ou les barrettes de lasers de puissance multirubans. En effet, dans ces dernières applications, le composant comporte également des régions électriquement isolées disposées entre une région d'injection de courant, et la localisation de l'injection de courant est également assurée par une couche d'isolation déposée avantageusement sur une couche d'accrochage selon l'invention.

## Revendications

1. Composant optique semi-conducteur (10) comprenant une région d'injection de courant (I) et au moins une région électriquement isolée dite premier plateau (P₁, P₂), contenant chacune une couche de contact (5_{P}, 5_{I}) en un alliage à base d'arséniure de gallium, GaAs, déposée sur une couche de confinement dite supérieure (23_{P}, 23_{I}) en un matériau semi-conducteur,
ledit composant comprenant en outre au niveau dudit premier plateau une couche d'isolation (7) en un matériau diélectrique située au-dessus de ladite couche de contact,
**caractérisé en ce qu'**une couche dite d'accrochage (6_{P}) est interposée entre ladite couche de contact et ladite couche d'isolation de manière à accroître l'adhérence de ladite couche d'isolation sur ladite couche de contact.

2. Composant optique semi-conducteur (10) selon la revendication 1 **caractérisé en ce que** ladite couche d'accrochage (6_{P}) est en un alliage à base de phosphore, et de préférence en un alliage à base de phosphore, de gallium et d'indium.

3. Composant optique semi-conducteur (10) selon l'une des revendications 1 ou 2 **caractérisé en ce que** ladite couche d'accrochage (6_{P}) a une épaisseur comprise entre 20 nm et 5000 nm et de préférence de l'ordre de 1000 nm.

4. Composant optique semi-conducteur (10) selon l'une des revendications 1 à 3 **caractérisé en ce que** ladite couche d'isolation (7) est en un matériau diélectrique choisi parmi les polyimides, les oxydes de métaux, la silice et les nitrures, et de préférence parmi les nitrures de silicium.

5. Composant optique semi-conducteur (10) selon l'une des revendications 1 à 4 **caractérisé en ce qu'**il comprend en outre une région électriquement isolée dite premier canal (C₁) entre ledit premier plateau (P₁) et ladite région d'injection de courant (I).

6. Composant optique semi-conducteur (10) selon la revendication 5 **caractérisé en ce qu'**il comprend en outre un deuxième plateau identique (P₂) audit premier plateau (P₁) et un deuxième canal (C₂) identique audit premier canal (C₁) disposé entre ledit deuxième plateau et ladite région d'injection de courant (I) de sorte que lesdits premier et deuxième canaux sont situés de part et d'autre de ladite région d'injection de courant.

7. Composant optique semi-conducteur (10) selon l'une des revendications 1 à 6 **caractérisé en ce que** ladite région d'injection de courant (I) ainsi que ledit ou lesdits plateaux (P₁, P₂) sont de forme sensiblement parallélépipédique, la hauteur de ladite région d'injection de courant (I) étant sensiblement inférieure à ladite hauteur dudit ou desdits plateaux.

8. Composant optique semi-conducteur (10) selon l'une des revendications 1 à 7 **caractérisé en ce qu'**il comprend en outre un substrat de type GaAs (1) sur lequel sont déposées successivement sur une même face :
- une couche de confinement dite inférieure (21) en un matériau semi-conducteur de préférence semblable audit matériau de ladite couche de confinement supérieure,
- une couche active (3) destinée à produire des rayonnements de type laser,
- une couche de confinement dite intermédiaire (22) en un matériau semi-conducteur de préférence semblable audit matériau de ladite couche de confinement inférieure,
- une couche dite de couverture intermédiaire (4) en un alliage à base de phosphore, ladite couche de confinement supérieure (23_{P}, 23_{I}) étant déposée sur ladite couche de couverture intermédiaire,
et **en ce qu'**il comprend en outre une couche électrode (8) en un matériau métallique couvrant ladite ou lesdites régions électriquement isolées (P₁, C₁, P₂, C₂) et ladite région d'injection de courant (I).

9. Composant optique semi-conducteur (10) selon la revendication 8 **caractérisé en ce que** ledit alliage de ladite couche d'accrochage (6_{P}) est identique audit alliage de ladite couche de couverture intermédiaire (4).

10. Procédé de fabrication d'un composant optique semi-conducteur comprenant une région d'injection de courant et au moins une région électriquement isolée et comportant les étapes suivantes :
- une étape de dépôt d'une couche de contact (5) en un alliage à base de GaAs sur une couche de confinement dite supérieure (23) en un matériau semi-conducteur,
- une étape ultérieure de dépôt d'une couche dite de masquage (71) en un matériau diélectrique de type nitrure de silicium sur ladite couche de contact,
**caractérisé en ce qu'**il comporte en outre une étape intermédiaire de dépôt d'une couche dite d'accrochage (6) entre ladite couche de contact et ladite couche de masquage de manière à accroître l'adhérence de ladite couche de masquage sur ladite couche de contact.

11. Procédé de fabrication selon la revendication 10 **caractérisé en ce que** ladite couche d'accrochage (6) est en un alliage à base de phosphore, et de préférence en un alliage à base de phosphore, de gallium et d'indium.

12. Procédé de fabrication selon l'une des revendications 10 ou 11 **caractérisé en ce qu'**il comporte en outre préalablement au dépôt de ladite couche de confinement supérieure (23) les étapes successives de dépôt suivantes sur une même face d'un substrat de type GaAs (1):
- dépôt d'une couche de confinement dite inférieure (21) en un matériau semi-conducteur de préférence semblable audit matériau de ladite couche de confinement supérieure,
- dépôt d'une couche active (3) destinée à produire des rayonnements de type laser,
- dépôt d'une couche de confinement dite intermédiaire (22), en un matériau semi-conducteur de préférence semblable audit matériau de ladite couche de confinement inférieure.

13. Procédé de fabrication selon la revendication 12 **caractérisé en ce qu'**il comporte en outre après le dépôt de ladite couche de confinement intermédiaire (22) une étape de dépôt d'une couche dite de couverture intermédiaire (4) en un alliage à base de phosphore, ladite couche de confinement supérieure (23) étant déposée sur ladite couche de couverture intermédiaire.

14. Procédé de fabrication selon l'une des revendications 10 à 13 **caractérisé en ce qu'**il comporte en outre après le dépôt de ladite couche de masquage (71) les étapes suivantes :
- une étape d'élimination partielle de ladite couche de masquage de manière à laisser partiellement apparente ladite couche d'accrochage (6),
- une étape ultérieure de gravure pour supprimer, au niveau de ladite ou desdites parties laissées apparentes par ladite étape d'élimination, ladite couche d'accrochage (6), ladite couche de contact (5) sous-jacente ainsi que ladite couche de confinement supérieure (23) sous-jacente,
- une étape ultérieure de dépôt d'une couche dite d'isolation (7) en un matériau diélectrique de type nitrure de silicium,
- une étape ultérieure dite d'ouverture pour supprimer ladite couche d'isolation (7) au moins au niveau d'une partie où ladite couche d'accrochage (6) est encore présente destinée à former ladite région d'injection de courant.

15. Procédé de fabrication selon la revendication 14 **caractérisé en ce qu'**il comporte en outre une autre étape de gravure dite de démasquage entre ladite étape de gravure et ladite étape de dépôt d'une couche d'isolation (7) pour supprimer entièrement ladite couche de masquage (71).

16. Procédé de fabrication selon l'une des revendications 14 ou 15 **caractérisé en ce qu'**il comporte en outre après ladite étape d'ouverture une étape de décapage pour supprimer ladite couche d'accrochage (6) au niveau de ladite partie destinée à former ladite région d'injection de courant.

17. Procédé de fabrication selon la revendication 16 **caractérisé en ce qu'**il comporte en outre après ladite étape de décapage une étape dite de métallisation comprenant le dépôt d'une couche électrode (8) en un matériau métallique pour recouvrir ladite ou lesdites régions électriquement isolées ainsi que ladite région d'injection de courant.

18. Composant optique semi-conducteur (10, 20, 30) obtenu par le procédé de fabrication selon l'une des revendications 10 à 17 **caractérisé en ce que** deux régions électriquement isolées (P₁, P₂, Is₁, Is₂) sont disposées de part et d'autre de ladite région d'injection de courant (I).
